# EUROPÄISCHE PATENTSCHRIFT

(11) **EP 3 122 613 B1**
(45) Veröffentlichungstag und Bekanntmachung des Hinweises auf die Patenterteilung: **08.05.2019**
(21) Anmeldenummer: 15710482.9
(22) Anmeldetag: 16.03.2015
(51) Int. Cl.: B62D 5/04, B62D 7/06

(54) **LENKVORRICHTUNG**
STEERING DEVICE
SYSTÈME DE DIRECTION

(30) Priorität: 25.03.2014 DE 102014004231
(43) Veröffentlichungstag der Anmeldung: 01.02.2017
(73) Patentinhaber: ThyssenKrupp Presta AG, 9492 Eschen (LI); thyssenkrupp AG, 45143 Essen (DE)
(72) Erfinder: POLMANS, Kristof, A-6464 Tarrenz (AT); HIRSCHMANN, Richard, 48067 Royal Oak (US)
(74) Vertreter: thyssenkrupp Intellectual Property GmbH
(86) Internationale Anmeldenummer: PCT/EP2015/055469
(87) Internationale Veröffentlichungsnummer: WO 2015/144482

(56) Entgegenhaltungen:
- EP-A1- 1 757 469
- WO-A1-2008/128379
- CN-U- 201 484 168
- DE-A1-102007 055 353
- FR-A1- 2 888 553
- FR-A1- 2 935 672
- US-A1- 2004 140 642
- John McElroy: "TECH REPORT: Ford RevoKnuckle", autoline.tv , 24. Februar 2009 (2009-02-24), XP002740105, Gefunden im Internet: URL:http://www.autoline.tv/journal/?cat=78 9&p=2934 [gefunden am 2015-05-27]

## Beschreibung

Die vorliegende Erfindung betrifft eine Lenkvorrichtung mit den Merkmalen des Oberbegriffs des Anspruchs 1.

Elektromechanische Servolenkungen unterstützen die vom Fahrer aufgebrachte Lenkkraft. Die Lenkkraft, die der Fahrer übers Lenkrad vorgibt, wird in einen Torsionsstab geleitet, der sich kraftabhängig verdreht. Dieses Drehmoment misst ein Sensor, der diese Information an ein elektronisches Steuergerät weiterreicht. Das wiederum gibt dem elektrischen Servomotor präzise Befehle, welches Zusatzdrehmoment in die Lenkung eingeleitet werden soll. Bei Steer-by-Wire-Systemen gibt es keine direkte mechanische Kopplung zwischen dem Lenkrad und dem Lenkgestänge und die Fahrzeugräder werden direkt mit Hilfe eines Servomotors bewegt.

Die lenkbaren Fahrzeugräder solcher Lenkungen sind in der Regel mit Spurstangen mechanisch zwangsgekoppelt. Eine exakte Spurführung jedes lenkbaren Fahrzeugrades und eine Verschwenkung der Räder um einen Lenkwinkel bis zu 90° sind damit nicht möglich.

Einzelradlenkungen können dieses Problem lösen. Sie sind zum Beispiel aus der EP 1 757 469 A1, WO 2008/128379 A1 und WO 2008/128421 A1 bekannt. Bei Einzelradlenkungen erfolgt die Verschwenkung der einzelnen Räder über einzelne Elektromotoren. Dabei sind die jeweiligen Stellmotoren mit den Fahrzeugrädern verbunden. Nachteilig ist, dass die Motoren aufgrund ihrer Lage die ungefederte Masse erhöhen. Auch die Flexibilität der Anordnung der Elektromotoren ist nicht sehr groß, so dass es zu Bauraumengpässen kommen kann. Weiterhin kann es zu Schwingungs- und Stoßbeanspruchungen des Motors und des Steuergeräts kommen.

Aus der CN 201 484 168 U ist eine gattungsgemäße Lenkungsvorrichtung bekannt, bei der zwischen einem Stellmotor und einem Rad ein als Kegelradgetriebe ausgebildetes Zahnradgetriebe angeordnet ist. Dieses ist schwer und kostspielig.

Es ist Aufgabe der vorliegenden Erfindung, eine Lenkvorrichtung bereitzustellen, die ein hohes Maß an Flexibilität mit möglichst geringer ungefederter Masse aufweist.

Diese Aufgabe wird von einer Lenkvorrichtung mit den Merkmalen des Anspruchs 1 gelöst.

Danach ist eine Lenkvorrichtung für ein Kraftfahrzeug zur Verschwenkung von wenigstens einem lenkbaren, an einer Aufhängung gegenüber einem Chassis des Kraftfahrzeugs gefedert angeordneten Fahrzeugrades, wobei das lenkbare Fahrzeugrad an einem Achsschenkel drehbar gelagert ist, und der Achsschenkel in wenigstens einem Schwenklager an der Aufhängung um eine Schwenkachse verdrehbar gelagert ist, mit wenigstens einem Stellmotor, der eine drehbare Abtriebswelle aufweist, vorgesehen, wobei der wenigstens eine Stellmotor an dem Chassis fest angeordnet ist, und wobei eine gelenkige Welle vorgesehen ist, die einerseits mit der Abtriebswelle des Stellmotors drehfest verbunden ist und die andererseits eine Verzahnung trägt, die mit einer mit dem Achsschenkel drehfest verbundenen Gegenverzahnung derart in Eingriff steht, dass eine Drehung der Abtriebswelle des Stellmotors eine Verdrehung des lenkbaren Fahrzeugrades um die Schwenkachse bewirkt, wobei die auf dem Achsschenkel drehfest angeordnete Gegenverzahnung ein Zahnrad ist, das mit der Verzahnung der Welle ein Zahnradgetriebe bildet, dadurch gekennzeichnet, dass das Zahnradgetriebe ein selbsthemmendes Schneckengetriebe ist.

Durch diese Lenkvorrichtung können die Fahrzeugräder mit hoher Flexibilität verschwenkt werden, wobei durch die spezielle Anordnung des Stellmotors die ungefederte Masse nicht erhöht wird und Bauraumengpässe vermieden werden können.

Bevorzugt ist der Achsschenkel Teil eines "revo knuckle" Konzepts. Diese Ausgestaltung verringert den Störkrafthebelarm, den so genannten Kingpin-Offset deutlich, wodurch die resultierenden Lenkradmomente reduziert werden.

Vorteilhafterweise ist der Stellmotor ein Elektromotor.

Weiterhin bevorzugt ist die gelenkige Welle eine Gelenkwelle mit einem Längenausgleich. In einer vorteilhaften Ausführungsform weisen die Getriebe eine variable Übersetzung auf. Dabei kann es vorgesehen sein, dass die Lenkvorrichtung genau einen Elektromotor und zwei lenkbare Räder aufweist, und dass die Gelenkwellen der zwei lenkbaren Fahrzeugräder miteinander drehfest verbunden sind. In dieser Ausführungsform werden die Fahrzeugräder über den vollen Lenkbereich parallel gelenkt. Dieser Effekt wird durch die variable Übersetzung der Getriebe aufgehoben.

In einer weiteren bevorzugten Ausführungsform ist die Lenkvorrichtung eine Einzelradlenkung, wobei jedem lenkbaren Fahrzeugrad genau ein Elektromotor zugeordnet ist. Dabei können zwei, drei oder insbesondere vier Fahrzeugräder lenkbar sein und entsprechen können zwei, drei oder vier Motoren, insbesondere Elektromotoren, vorgesehen sein. Dadurch wird die Flexibilität der Lenkung weiter erhöht.

Es kann auch vorgesehen sein, dass die Lenkvorrichtung Teil einer Allrad-Lenkung mit vier lenkbaren Fahrzeugrädern ist.

Bevorzugt ist die Lenkvorrichtung Teil einer Steer-by-Wire Lenkung.

Es kann weiterhin vorgesehen sein, den Stellmotor in einer baulichen Einheit mit einem karosseriefesten elektrischen Rad- oder Achsantrieb eines elektrischen Fahrzeugantriebs anzuordnen. Dabei ist es vorteilhaft, wenn das Steuergerät des wenigstens einen Elektromotors baulich in einem Steuergerät des elektrischen Fahrzeugantriebs integriert ist.

Zudem ist es bevorzugt, dass wenigstens zwei Elektromotoren vorgesehen sind, die redundant ausgelegt sind. Im Falle einer Störung eines Elektromotors übernimmt der andere Elektromotor die Verschwenkung der zu lenkenden Fahrzeugräder. Es ist allerdings auch denkbar und möglich, dass im Falle einer Störung ein Fahrzeugrad nicht mehr verschwenkt werden kann, insbesondere durch Ausfall des für dieses Rad vorgesehenen motorischen Antriebs der Verschwenkung. In diesem Fall kann eine gewisse Redundanz dadurch gebildet sein, dass das mindestens eine weitere verschwenkbare Fahrzeugrad soweit übersteuert verschwenkt wird, dass die gewünschte Fahrtrichtungsänderung noch erreicht wird, oder doch angenähert erreicht wird. Dadurch kann zumindest eine Notfunktion realisiert werden, die ein vergleichsweise sicheres Anhalten des Fahrzeuges ermöglicht, verglichen mit einem völlig ungesteuerten Zustand. Dabei kann entweder die Steuerung die Überkompensation im Falle des Erkennens des Fehlerzustandes einstellen oder der Fahrer dies manuell durch ein weiteres Lenken, bis die notwendige Bahn zumindest angenähert erreicht wird, einstellen.

Bevorzugte Ausführungsformen der Erfindung werden nachfolgend anhand der Zeichnungen näher erläutert. Für gleiche oder funktionsgleiche Elemente werden in allen Zeichnungen die gleichen Bezugszeichen verwendet. Es zeigen:
- Fig. 1:: eine schematische Darstellung einer Steer-by-Wire Lenkung mit Einzelradlenkung,
- Fig. 2:: eine räumliche Ansicht der Einzelradlenkung aus Fig. 1,
- Fig. 3:: eine räumliche Ansicht der Einzelradlenkung in Ansicht von oben,
- Fig. 4:: eine Explosionszeichnung der Einzelradlenkung in Ansicht von der Seite,
- Fig. 5:: eine schematische Darstellung eines Redundanzkonzeptes,
- Fig. 6:: eine schematische Darstellung einer elektromechanischen Lenkung mit Einzelradlenkung,
- Fig. 7:: eine schematische Darstellung einer Steer-by-Wire Lenkung mit elektrischem Fahrzeugantrieb,
- Fig. 8:: eine schematische Darstellung einer elektromechanischen Hilfskraftlenkung, sowie
- Fig. 9: eine schematische Darstellung einer Einzelradlenkung als Steer-by-Wire-Lenkung mit mechanischer Rückfallebene.

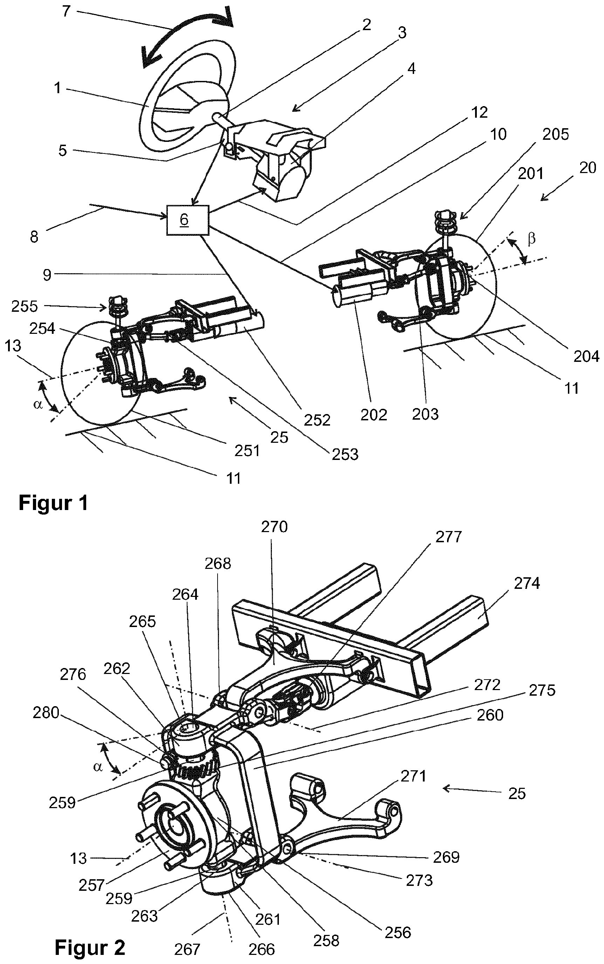

Die Figur 1 zeigt eine Steer-by-Wire-Lenkung mit Einzelradlenkung. Die Steer-by-Wire-Lenkung weist folgende Hauptkomponenten auf: ein Lenkrad 1, eine mit dem Lenkrad 1 verbundene Lenkwelle 2, eine die Lenkwelle 2 teilweise umgebende Lenksäule 3 mit darin angeordnetem Lenkkraftsteller 4, einen mit der Lenkwelle 2 verbundenen Drehsignalsensor 5, eine Steuerungs- und Regeleinheit 6 und zwei von der Steuerungs- und Regeleinheit 6 gesteuerte Einzelradlenkeinheiten 20, 25. Als Drehsignalsensor wird bevorzugt ein Drehwinkelsensor eingesetzt. Es ist jedoch auch denkbar und möglich, einen Drehmomentsensor und/oder eine Kombination aus beiden einzusetzen.

Die von einem Fahrer über das Lenkrad 1 in die Lenkwelle 2 eingebrachte Lenkbewegung 7 wird von dem Drehsignalsensor 5 gemessen und an die Steuerungs- und Regeleinheit 6 geleitet. Weiterhin werden andere Signale 8, wie beispielsweise die Fahrzeuggeschwindigkeit der Steuerungs- und Regeleinheit 6 zugeführt. Daraus bestimmt die Steuerungs- und Regeleinheit 6 Lenksteuersignale 9, 10 zur Weiterleitung an die Einzelradlenkeinheiten 20, 25. Um dem Fahrer das gewohnte Lenkgefühl und die damit verbundenen Informationen zum Zustand des Kraftfahrzeuges und der Fahrbahn 11 zu vermitteln, errechnet die Steuerungs- und Regeleinheit 6 einen Stellwert 12 für den Lenkkraftsteller 4, der ein Gegendrehmoment in die Lenkwelle 2 einbringt.

Es ist jeweils eine Einzelradlenkeinheit 20, 25 für ein zu lenkendes Rad 201, 251 vorgesehen. Eine Einzelradlenkeinheit 20, 25 umfasst einen Elektromotor 202, 252, eine teleskopierbare Gelenkwelle 203, 253, ein Getriebe 204, 254, einen Achsschenkel, einen unteren Querlenker, einen oberen Querlenker und einen Dämpfer 205, 255.

Die Lenksteuersignale 9, 10 die zu den Einzelradlenkeinheiten 20, 25 geleitet werden, steuern die Elektromotoren 202, 252, die eine Verschwenkung der Fahrzeugräder 201, 251 um den jeweiligen gewünschten Schwenkwinkel α, β bewirken. Durch die mit dem Elektromotor 202, 252 verbundene Gelenkwelle 203, 253 wird die Drehung der Abtriebswelle des Elektromotors auf das Getriebe 204, 254 übertragen und damit die Schwenkbewegung der Fahrzeugräder 201, 251 eingeleitet.

Figur 2 zeigt eine vergrößerte Ansicht einer Einzelradlenkeinheit 25.

Auf einer Antriebsachse 13 eines Fahrzeugrades 251 ist ein Achsschenkel 256 mit einer Nabe 257, die um die Antriebsachse 13 drehbar in einem Lager 258 gelagert ist, vorgesehen. Der Achsschenkel 256 weist winklig, zum Beispiel senkrecht, zur Antriebsachse 13 ausgerichtete Lagerzapfen 259 auf. Ein im wesentlichen O-förmiger Rahmen 260 weist zwei gegenüberliegende, den Rahmen überragende Abschnitte 261, 262 auf, in denen Bohrungen 263, 264 vorgesehen sind. Diese Bohrungen 263, 264 sind von dem jeweiligen Lagerzapfen 259 durchsetzt, so dass sich Schwenklager 265, 266 ausbilden. Diese Schwenklager 265, 266 ermöglichen eine Verschwenkung des Achsschenkels 256 und der Nabe 257 um eine mit der Längsachse der Lagerzapfen 259 übereinstimmende erste Schwenkachse 267. Auf der gegenüberliegenden Seite der Schwenklager 265, 266 weist der Rahmen 260 zwei weitere Schwenklager 268, 269 auf, an die das jeweilige äußere Ende des oberen Querlenkers 270 bzw. des unteren Querlenkers 271 angelenkt ist. Die Querlenker 270, 271 sind vertikal verschwenkbar um eine zweite bzw. dritte Schwenkachse 272, 273 angeordnet, die senkrecht zur ersten Schwenkachse 267 ausgerichtet ist. Die Querlenker 270, 271 gabeln sich U-förmig von dem ersten Schwenklager 268, 269 in einwärtiger Richtung. Die inneren Enden des oberen und des unteren Querlenkers 270, 271 sind wiederum vertikal verschwenkbar an einem Chassis 274 angelenkt. Diese Anlenkung ist hier nur für den oberen Querlenker 270 dargestellt.

Zwischen Achsschenkel 256 und Rahmen 260 ist auf dem Lagerzapfen 259 ein Zahnrad 275 drehfest angeordnet. Dieses Zahnrad 275 kämmt mit einer Schneckenverzahnung 276 einer Antriebsspindel 280 der teleskopierbaren Gelenkwelle 253, die mit einer nicht dargestellten Abtriebswelle des Elektromotors 252 drehfest verbunden ist.

Der Elektromotor 252 ist dabei am Chassis 274 befestigt. Die Gelenkwelle 253 weist ein motorseitiges Kreuzgelenk 277 und, hier nicht dargestellt, ein getriebeseitiges Kreuzgelenk und ein dazwischen angeordnete Schiebestück auf. Das Schiebestück besteht aus einer inneren Längsverzahnung, die auf der Gelenkwelle angeordnet ist, und aus einem Gegenstück mit Innenverzahnung.

Die von der Steuerungs- und Regeleinheit 6 bestimmten Lenksteuersignale 9, 10 werden an die Einzelradlenkeinheiten 20, 25 weitergeleitet. Entsprechend wird der jeweilige Elektromotor 202, 252 angetrieben. Die Drehung des Elektromotors 252 wird mittels der Gelenkwelle 253 auf das Getriebe 254 übertragen, was eine Schwenkbewegung der nicht dargestellten Fahrzeugräder um die erste Schwenkachse 267 mit einem gewünschten Schwenkwinkel □ bewirkt. Prinzipiell ist es, im Falle einer hier nicht dargestellten Konstruktion, auch möglich das Fahrzeugrad um 360° und mehr zu verschwenken. Durch die Einzelradlenkung ist es möglich die Fahrzeugräder mit einem sehr großen Schwenkwinkel zu verschwenken, so dass das Kraftfahrzeug zum Beispiel unter einem sehr steilen Winkel aus einer sehr engen Parklücke herausmanövriert werden kann. Da die Elektromotoren unabhängig voneinander gestellt werden können, sind spezielle Fahrkinematiken möglich, die ohne Einzelradlenkung nicht erreichbar wären. So können die Fahrzeugräder den theoretischen Ackermannwinkel einschlagen, was zu einer Minimierung des Reifenverschleißes führt und die Querdynamik des Kraftfahrzeugs erhöht. Durch die Lage der Schwenkachse 267 der Fahrzeugräder im Achsschenkel 256 (sog. Revo Knuckle Konzept) ist es möglich, den Hebelarm der Antriebskräfte um die Schwenkachse, den sogenannten Störkrafthebelarm oder Kingpin-Offset, deutlich zu verringern und so die resultierenden Lenkradmomente zu reduzieren.

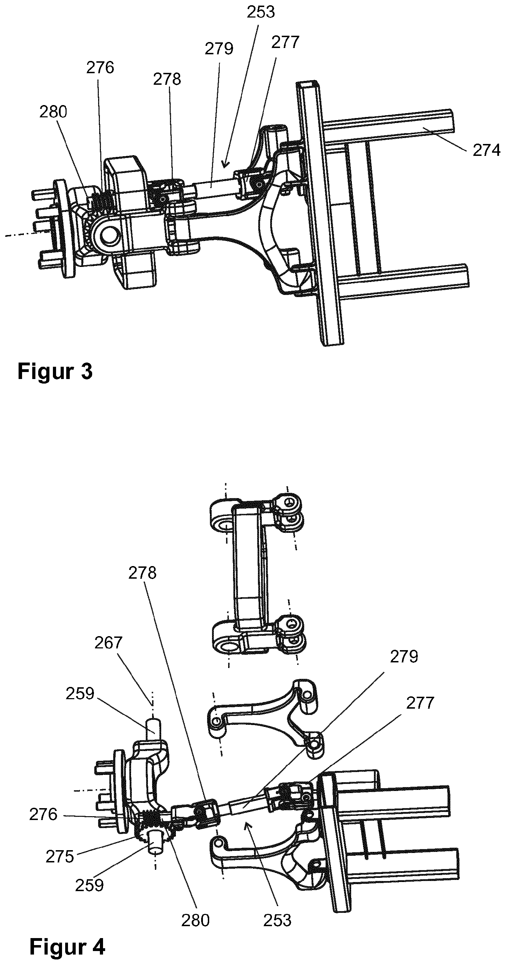

Die Figuren 3 und 4 zeigen zwei weitere Ansichten der erfindungsgemäßen Lenkvorrichtung, wobei besonders die Ausgestaltung der teleskopierbaren Gelenkwelle 253 ersichtlich ist. Die Gelenkwelle 253 weist das motorseitige Kreuzgelenk 277, das getriebeseitige Kreuzgelenk 278 und das dazwischen angeordnete Schiebestück 279 und die Antriebswelle 280 und die darauf angebrachte Schneckenverzahnung 276 auf.

Um in dem Fall einer Störung der Einzelradlenkung die Steuerbarkeit des Kraftfahrzeuges zu gewährleisten, können zum Beispiel folgende Redundanzkonzepte vorgesehen sein:

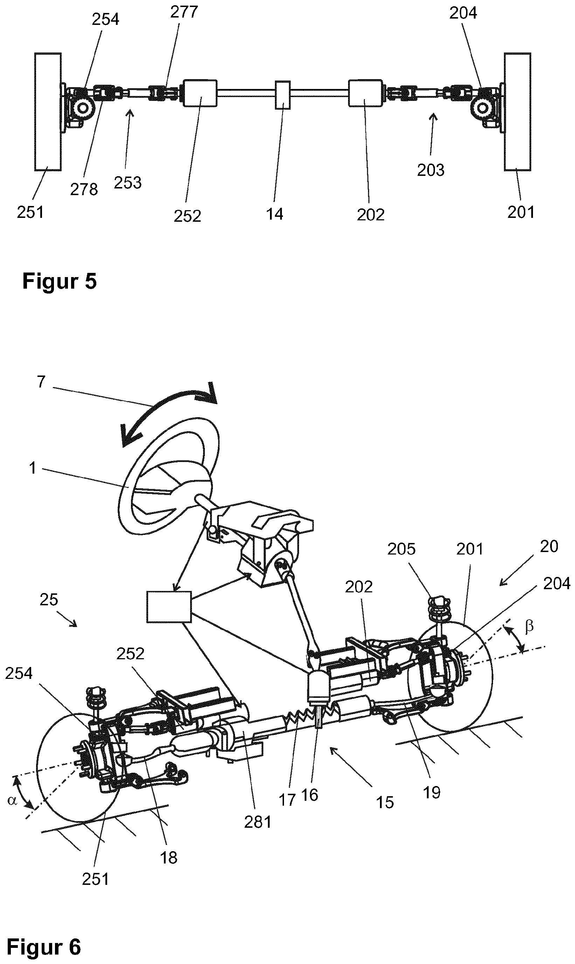

Figur 5 zeigt schematisch die Anordnung einer Sicherheitskupplung 14 zwischen den beiden Elektromotoren 202, 252. Wenn einer der Elektromotoren ausfällt kann diese Kupplung geschlossen werden und der jeweils andere Elektromotor kann die Lenkung der Räder 201, 251 übernehmen. Zur Erhöhung der Redundanz könnte auch die Steuer- und Regeleinheit durch zwei voneinander getrennte Steuerungen ersetzt werden.

Figur 6 zeigt eine Ausführungsform der erfindungsgemäßen Lenkvorrichtung, bei der eine klassische mechanische Lenkeinrichtung 15, mit einem Getriebe aus Ritzel 16 und Zahnstange 17, durch den Einsatz von zwei erfindungsgemäßen Einzelradlenkmechanismen 20, 25 die Funktion einer elektromechanischen Servolenkung erhält. Auf diese Weise kann das gewünschte Rückstellmoment an den Fahrer in der allgemein bekannten Weise bereitgestellt werden und ein Lenkkraftsteller ist nicht erforderlich. Mit Vorteil kann jedoch eine Kupplung 281 vorgesehen sein, die im Falle eines Einparkvorgangs ausgekuppelt wird, so dass die Fahrzeugräder 201 und 251 unabhängig voneinander gesteuert werden können und eine vergrößerte Verschwenkbewegung der Fahrzeugräder 201, 251 um die Schwenkachse 267 ermöglicht wird. Dadurch kann das Einparken erleichtert werden. Durch den Einsatz von zwei Motoren können darüber hinaus Motoren mit weniger Antriebsleistung eingesetzt werden und es ist zudem eine Redundanz möglich.

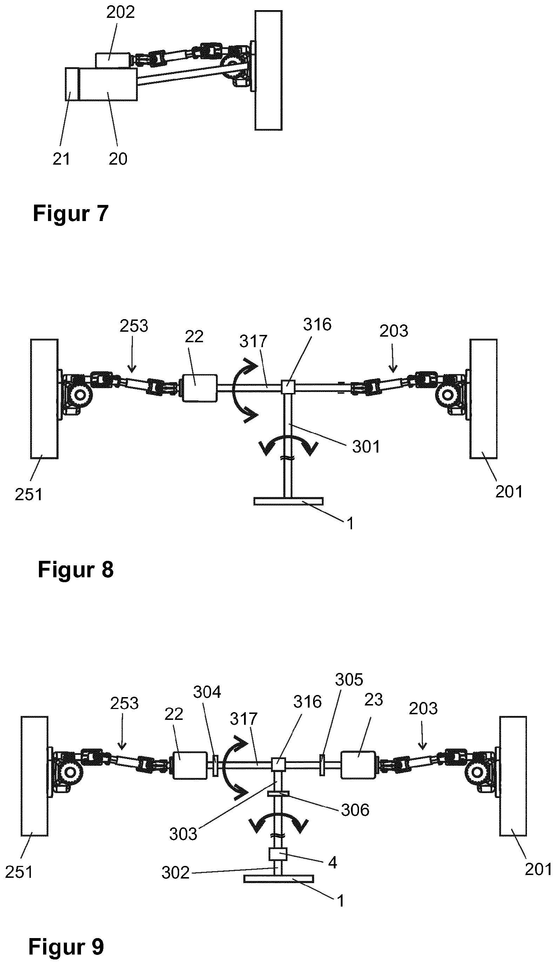

Wie in Figur 7 dargestellt ist, kann im Fall eines radnahen, auf der Vorderachse angeordneten karosseriefesten elektrischen Fahrzeugantriebs 20 der Elektromotor 202 in einer baulichen Einheit mit dem elektrischen Fahrzeugantriebs 20 angeordnet sein. Dabei kann vorgesehen sein, dass das Steuergerät des Elektromotors 202 baulich in einem Steuergerät 21 des elektrischen Fahrzeugantriebs 20 integriert ist.

Figur 8 zeigt eine schematische Anordnung einer elektromechanischen Hilfskraftlenkung, die die Drehbewegung des Fahrers am Lenkrad 1 mechanisch über eine Lenkwelle 301 und ein Zahnrad 316 auf eine Welle 317 überträgt. An den Enden der Welle 317 sind teleskopierbare Gelenkwellen 203, 253 angelenkt, die die Fahrzeugräder 201, 251, bei einer Rotation der Welle 317 entlang um ihre Längsachse, verschwenken. In diesem Fall werden die Fahrzeugräder 201, 251 über den vollen Lenkbereich parallel gelenkt. Auch hier kann eine variable Übersetzung der Getriebe Abhilfe schaffen. Die Rotation der Welle 317 wird durch einen Elektromotor 22 unterstützt.

Figur 9 zeigt eine schematische Anordnung einer elektromechanischen Hilfskraftlenkung als Steer-by-Wire-Lenkung mit mechanischer Rückfallebene. Der Fahrer bringt in das Lenkrad 1 eine Lenkbewegung in die obere Lenkwelle 302 ein, wobei über einen nicht dargestellten Lenkmomentensteller 4 dem Fahrer ein Gegenlenkmoment vermittelt wird. Auf Basis der eingebrachten Lenkbewegung werden die Motoren 22 und 23 angesteuert und die Lenkbewegung, das heißt die Verschwenkung der Fahrzeugräder 201, 251, über die Gelenkwellen 203. 253 eingeleitet, wie am Beispiel anderer Ausführungsformen der Erfindung oben bereits erläutert. Während des normalen Steer-by-Wire-Betriebes sind dabei die Kupplungen 304, 305, 306 geöffnet, so dass die obere Lenkwelle 302 und die beiden Gelenkwellen 203, 253 unabhängig voneinander angesteuert werden können. Im Falle eines Ausfalls eines der beiden Antriebsmotoren 22 oder 23 können die Kupplungen 304 und 305 geschlossen werden, so dass ein einziger Antriebsmotor die Lenkbewegung, allerdings dann für beide Fahrzeugräder 201, 251 synchron, übernimmt. Im Falle eines Ausfalls beider Antriebsmotoren 22, 23 und/oder des Lenkmomentenstellers 4 können alle Kupplungen 304, 305, 306 geschlossen werden, so dass die Drehbewegung der oberen Lenkwelle 302 mit der Drehbewegung der unteren Lenkwelle 303 und dem Zahnrad 316 gekoppelt ist. Bei Drehung des Zahnrads 316 wird die Welle 317 in Drehung versetzt und über die geschlossene Kupplung die Gelenkwellen 203, 253 in Drehung versetzt. Entsprechend erfolgt die Verschwenkung der Fahrzeugräder 201, 251.

In Abwandlung zur Ausführungsform, wie sie in Figur 9 veranschaulicht ist, kann auch nur eine der beiden Kupplungen 304, 305 zwischen den Antriebsmotoren 22,23 vorgesehen sein. Damit könnte weitgehend die gleiche Funktionalität sichergestellt werden. Im Steer-by-Wire-Betrieb sind beide Kupplungen, Kupplung 304 oder Kupplung 305 und die Kupplung 306, geöffnet. Im Fehlerfall werden beide Kupplungen geschlossen.

In allen Ausführungsbeispielen kann es auch vorgesehen sein, einen herkömmlichen Achsschenkel einzusetzen, bei dem das Getriebe am unteren oder oberen Querträger integriert ist. Dann ist allerdings eine kardanische Kupplung zwischen Getriebe und Achsschenkel notwendig. Das Getriebe kann sowohl mit einem Doppelquerlenker als auch mit einer McPherson Aufhängung kombiniert werden.

Bevorzugt ist das Zahnradgetriebe als Schneckengetriebe ausgestaltet. Anstelle eines Schneckengetriebes können aber auch andere Getriebearten oder Kombinationen von Getrieben verwendet werden.

Durch die Gestaltung der erfindungsgemäßen Lenkvorrichtung besteht eine hohe Flexibilität in Bezug auf die Anordnung des Elektromotors. Insbesondere ist der Elektromotor nicht lokal am Fahrzeugrad sondern am Chassis befestigt, so dass er nicht mit in die ungefederte Masse eingeht. Weiterhin sind Lenkwinkel der lenkbaren Räder bis 90° (einseitig) möglich.

Ein derartiges System kann auch für eine Allrad-Lenkung eingesetzt werden, so dass sowohl die Vorderräder als auch die Hinterräder die erfindungsgemäße Lenkvorrichtung aufweisen.

## Patentansprüche

1. Lenkvorrichtung für ein Kraftfahrzeug zur Verschwenkung von wenigstens einem lenkbaren, an einer Aufhängung gegenüber einem Chassis (274) des Kraftfahrzeugs gefedert angeordneten Fahrzeugrades (201, 251), wobei das lenkbare Fahrzeugrad (201, 251) an einem Achsschenkel (256) drehbar gelagert ist, und der Achsschenkel (256) in wenigstens einem Schwenklager (265, 266) an der Aufhängung um eine Schwenkachse (267) verdrehbar gelagert ist, mit wenigstens einem Stellmotor (202, 252), der eine drehbare Abtriebswelle aufweist, wobei der wenigstens eine Stellmotor (202, 252) an dem Chassis (274) fest angeordnet ist, wobei eine gelenkige Welle (253) vorgesehen ist, die einerseits mit der Abtriebswelle des Stellmotors (202, 252) drehfest verbunden ist und die andererseits eine Verzahnung trägt, die mit einer mit dem Achsschenkel (256) drehfest verbundenen Gegenverzahnung derart in Eingriff steht, dass eine Drehung der Abtriebswelle des Stellmotors (202, 252) eine Verdrehung des lenkbaren Fahrzeugrades (201, 205) um die Schwenkachse (267) bewirkt, und die auf dem Achsschenkel (256) drehfest angeordnete Gegenverzahnung ein Zahnrad (275) ist, das mit der Verzahnung (204) der Welle ein Zahnradgetriebe (254) bildet, **dadurch gekennzeichnet, dass** das Zahnradgetriebe (204, 254) ein selbsthemmendes Schneckengetriebe ist.

2. Lenkvorrichtung nach einem der vorhergehenden Ansprüche, **dadurch gekennzeichnet, dass** der Achsschenkel (256) Teil eines "revo knuckle" Konzepts ist.

3. Lenkvorrichtung nach einem der vorhergehenden Ansprüche, **dadurch gekennzeichnet, dass** der Stellmotor ein Elektromotor (202, 252) ist.

4. Lenkvorrichtung nach einem der vorhergehenden Ansprüche, **dadurch gekennzeichnet, dass** die gelenkige Welle eine Gelenkwelle (203, 253) mit einem Längenausgleich ist.

5. Lenkvorrichtung nach einem der vorhergehenden Ansprüche, **dadurch gekennzeichnet, dass** die Getriebe (204, 254) eine variable Übersetzung aufweisen.

6. Lenkvorrichtung nach einem der vorhergehenden Ansprüche, **dadurch gekennzeichnet, dass** die Lenkvorrichtung genau einen Elektromotor (22) und zwei lenkbare Räder (201, 251) aufweist, und dass die Gelenkwellen (203, 253) der zwei lenkbaren Fahrzeugräder (201, 251) miteinander drehfest verbunden sind.

7. Lenkvorrichtung nach einem der vorhergehenden Ansprüche 1 bis 5, **dadurch gekennzeichnet, dass** die Lenkvorrichtung eine Einzelradlenkung ist, wobei jedem lenkbaren Fahrzeugrad (201, 251) ein Elektromotor (202, 252) zugeordnet ist.

8. Lenkvorrichtung nach einem der vorhergehenden Ansprüche, **dadurch gekennzeichnet, dass** die Lenkvorrichtung Teil einer Allrad-Lenkung mit vier lenkbaren Fahrzeugrädern (201, 251) ist.

9. Lenkvorrichtung nach einem der vorhergehenden Ansprüche, **dadurch gekennzeichnet, dass** die Lenkvorrichtung Teil einer Steer-by-Wire Lenkung ist.

10. Lenkvorrichtung nach einem der vorhergehenden Ansprüche, **dadurch gekennzeichnet, dass** der Stellmotor (202, 252) in einer baulichen Einheit mit einem karosseriefesten elektrischen Rad- oder Achsantrieb eines elektrischen Fahrzeugantriebs (20) angeordnet ist.

11. Lenkvorrichtung nach Anspruch 10, **dadurch gekennzeichnet, dass** das Steuergerät des wenigstens einen Elektromotors (202, 252) baulich in einem Steuergerät (21) des elektrischen Fahrzeugantriebs (20) integriert ist.

12. Lenkvorrichtung nach einem der vorhergehenden Ansprüche, **dadurch gekennzeichnet, dass** wenigstens zwei Elektromotoren (202, 252) vorgesehen sind, die redundant ausgelegt sind.

## Claims

1. Steering apparatus for a motor vehicle for pivoting at least one steerable vehicle wheel (201, 251) which is arranged on a suspension system in a sprung manner with respect to a chassis (274) of the motor vehicle, the steerable vehicle wheel (201, 251) being mounted rotatably on a steering knuckle (256), and the steering knuckle (256) being mounted in at least one pivot bearing (265, 266) on the suspension system such that it can be rotated about a pivoting axis (267), with at least one actuating motor (202, 252) which has a rotatable output shaft, the at least one actuating motor (202, 252) being arranged fixedly on the chassis (274), a hinged shaft (253) being provided which is connected fixedly on one side to the output shaft of the actuating motor (202, 252) so as to rotate with it and, on the other side, supports a toothing system which is in engagement with a mating toothing system which is connected fixedly to the steering knuckle (256) so as to rotate with it, in such a way that a rotation of the output shaft of the actuating motor (202, 252) brings about a rotation of the steerable vehicle wheel (201, 205) about the pivoting axis (267), and the mating toothing system which is arranged fixedly on the steering knuckle (256) so as to rotate with it being a gearwheel (275) which forms a gearwheel mechanism (254) with the toothing system (204) of the shaft, **characterized in that** the gearwheel mechanism (204, 254) is a self-locking worm gear mechanism.

2. Steering apparatus according to one of the preceding claims, **characterized in that** the steering knuckle (256) is part of a "RevoKnuckle" concept.

3. Steering apparatus according to either of the preceding claims, **characterized in that** the actuating motor is an electric motor (202, 252).

4. Steering apparatus according to one of the preceding claims, **characterized in that** the hinged shaft is an articulated shaft (203, 253) with a length compensation means.

5. Steering apparatus according to one of the preceding claims, **characterized in that** the gear mechanisms (204, 254) have a variable transmission ratio.

6. Steering apparatus according to one of the preceding claims, **characterized in that** the steering apparatus has precisely one electric motor (22) and two steerable wheels (201, 251), and **in that** the articulated shafts (203, 253) of the two steerable vehicle wheels (201, 251) are connected fixedly to one another so as to rotate together.

7. Steering apparatus according to one of the preceding Claims 1 to 5, **characterized in that** the steering apparatus is a single-wheel steering system, each steerable vehicle wheel (201, 251) being assigned an electric motor (202, 252).

8. Steering apparatus according to one of the preceding claims, **characterized in that** the steering apparatus is part of an all-wheel steering system with four steerable vehicle wheels (201, 251).

9. Steering apparatus according to one of the preceding claims, **characterized in that** the steering apparatus is part of a steer-by-wire steering system.

10. Steering apparatus according to one of the preceding claims, **characterized in that** the actuating motor (202, 252) is arranged in a structural unit with an electric wheel or axle drive of an electric vehicle drive (20), which electric wheel or axle drive is fixed on the vehicle body.

11. Steering apparatus according to Claim 10, **characterized in that** the control unit of the at least one electric motor (202, 252) is integrated structurally into a control unit (21) of the electric vehicle drive (20).

12. Steering apparatus according to one of the preceding claims, **characterized in that** at least two electric motors (202, 252) are provided which are of redundant design.

## Revendications

1. Système de direction pour un véhicule automobile servant au pivotement d'au moins une roue de véhicule orientable (201, 251) disposée de manière suspendue sur une suspension par rapport à un châssis (274) du véhicule automobile, la roue de véhicule orientable (201, 251) étant montée rotative sur une fusée d'essieu (256), et la fusée d'essieu (256) étant montée de manière à pouvoir tourner autour d'un axe de pivotement (267) dans au moins un palier de pivotement (265, 266) sur la suspension, comprenant au moins un servomoteur (202, 252) qui comprend un arbre de sortie rotatif, ledit au moins un servomoteur (202, 252) étant disposé fixement sur le châssis (274), un arbre articulé (253) étant prévu, lequel est d'une part relié de manière solidaire en rotation à l'arbre de sortie du servomoteur (202, 252) et porte d'autre part une denture qui s'engrène avec une denture complémentaire reliée de manière solidaire en rotation à la fusée d'essieu (256), de telle sorte qu'une rotation de l'arbre de sortie du servomoteur (202, 252) provoque une rotation de la roue de véhicule orientable (201, 205) autour de l'axe de pivotement (267), et la denture complémentaire disposée de manière solidaire en rotation sur la fusée d'essieu (256) étant une roue dentée (275) qui forme, avec la denture (204) de l'arbre, une transmission par engrenage (254), **caractérisé en ce que** la transmission par engrenage (204, 254) est une transmission à vis sans fin autobloquante.

2. Système de direction selon l'une des revendications précédentes, **caractérisé en ce que** la fusée d'essieu (256) fait partie d'une conception « revo knuckle ».

3. Système de direction selon l'une des revendications précédentes, **caractérisé en ce que** le servomoteur est un moteur électrique (202, 252) .

4. Système de direction selon l'une des revendications précédentes, **caractérisé en ce que** l'arbre articulé est un arbre de transmission (203, 253) doté d'une compensation de longueur.

5. Système de direction selon l'une des revendications précédentes, **caractérisé en ce que** la transmission (204, 254) présente un rapport variable.

6. Système de direction selon l'une des revendications précédentes, **caractérisé en ce que** le système de direction comprend exactement un moteur électrique (22) et deux roues orientables (201, 251), et **en ce que** les arbres de transmission (203, 253) des deux roues de véhicule orientables (201, 251) sont reliés l'un à l'autre de manière solidaire en rotation.

7. Système de direction selon l'une des revendications précédentes 1 à 5, **caractérisé en ce que** le système de direction est une direction individuelle de roue, un moteur électrique (202, 252) étant associé à chaque roue de véhicule orientable (201, 251).

8. Système de direction selon l'une des revendications précédentes, **caractérisé en ce que** le système de direction fait partie d'une direction toutes roues directrices comprenant quatre roues de véhicule orientables (201, 251).

9. Système de direction selon l'une des revendications précédentes, **caractérisé en ce que** le système de direction fait partie d'une direction « steer-by-wire ».

10. Système de direction selon l'une des revendications précédentes, **caractérisé en ce que** le servomoteur (202, 252) est disposé dans une unité structurale comprenant un entraînement de roue ou d'essieu électrique, solidaire de la carrosserie, d'une propulsion électrique de véhicule (20).

11. Système de direction selon la revendication 10, **caractérisé en ce que** l'appareil de commande dudit au moins un moteur électrique (202, 252) est intégré de manière structurale dans un appareil de commande (21) de la propulsion électrique de véhicule (20).

12. Système de direction selon l'une des revendications précédentes, **caractérisé en ce qu'**au moins deux moteurs électriques (202, 252) sont prévus, lesquels sont conçus de manière redondante.
